# DEMANDE DE BREVET EUROPEEN

(11) **EP 0 902 489 A1**
(43) Date de publication de la demande: **17.03.1999**
(21) Numéro de dépôt: 98402194.9
(22) Date de dépôt: 04.09.1998
(51) Int. Cl.: H01L 43/06

(54) **Capteur à effet hall**

(30) Priorité: 09.09.1997 FR 9711162
(71) Demandeur: THOMSON CSF, 75008 Paris (FR)
(72) Inventeur: Adam, Didier, 94117 Arcueil Cedex (FR); Landesman, Jean-Pierre, 94117 Arcueil Cedex (FR)

(57) **Abrégé**

L'invention concerne un capteur à Effet Hall à base de matériaux semiconducteurs de type GaAs ou lnP. Le capteur selon l'invention comprend en outre un substrat, une structure isolante et un canal dopé. La structure isolante comprend avantageusement une couche à base d'oxyde d'aluminium.

L'invention concerne aussi un procédé de réalisation d'un tel capteur à Effet Hall. Ce procédé comprend notamment une étape de dépôt d'aluminium sur un ensemble de couches semiconductrices, puis le chauffage à une température comprise entre environ 350°C et 450°C sous atmosphère oxydante pour transformer l'aluminium en oxyde d'aluminium isolant.

La couche barrière en oxyde d'aluminium conduit à une très bonne isolation du canal dopé et donc à une augmentation des performances de ce type de capteur à Effet Hall.

## Description

Le domaine de l'invention est celui des capteurs et sondes à effet Hall qui utilisent les variations de résistance d'un élément semiconducteur, en fonction d'un champ magnétique appliqué.

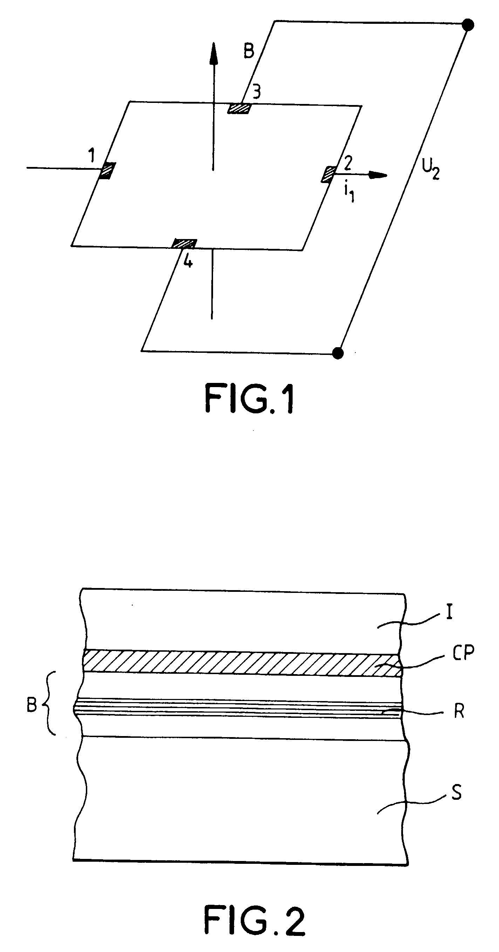

Plus précisément, une différence de potentiel U2 apparaît entre les bornes 3 et 4 d'une plaquette illustrée en figure 1, dans laquelle circule longitudinalement un courant de commande i1 entre les bornes 1 et 2, lorsque la plaquette est soumise perpendiculairement à un champ magnétique B.

Il s'agit typiquement d'un support isolant comportant un canal semiconducteur dopé dans lequel circule le courant. Avantageusement ces canaux peuvent être réalisés à partir de matériaux du type GaAs (tels que GalnAs et GaAlAs) épitaxiés sur des substrats isolants et ainsi fournir des sondes pouvant être utilisées dans de larges gammes de températures (-30°C à 130°C).

Les trois principales utilisations de ce type de sondes exploitent :
- le courant de commande maintenu constant. La tension de Hall mesure alors le champ magnétique. Grâce à leur très faible épaisseur, on peut introduire ces sondes dans des entrefers extrêmement petits. Elles sont indiquées pour des circuits de commande d'appareils industriels.
- la tension de Hall, influencée par un champ variable. Le courant de commande continu est transformé en une tension de Hall alternative proportionnelle au champ variable. Un courant de commande haute fréquence appliqué à un générateur à effet Hall peut être modulé avec un champ de commande oscillant, au rythme d'une basse fréquence ;
- la conversion d'un courant de commande variable et d'un champ magnétique variable en une quantité électrique proportionnelle qui est la tension de Hall (multiplicateur de Hall). L'exemple le plus simple est la mesure d'une puissance en partant d'un courant et d'une tension, ou la mesure du couple d'un moteur à courant continu en partant de l'induction dans l'entrefer et du courant dans l'inducteur. Les multiplicateurs de Hall sont aussi utilisés pour effectuer le produit ou le quotient de grandeurs physiques qui deviennent courants électriques proportionnels.

Dans ces applications, la garantie des performances des capteurs utilisant un canal dopé sur des matériaux à base de GaAs (ou lnP), outre la forte sensibilité du coefficient de Hall (tension V2), est liée à la faible dérive des propriétés de transport des électrons, en fonction de la température. Généralement, le canal dopé, utilisé pour l'effet Hall, présente une résistance assez élevée (quelques kΩ), il est isolé du substrat par une couche d'isolation nommée « buffer ». Mais l'élévation de température induit un canal parasite dans le buffer qui provoque une dérive importante des coefficients de Hall (liés au nombre de porteurs), incompatible avec le fonctionnement à températures élevées.

Actuellement, pour réduire la dérive en fonction de la température, l'isolation du canal dopé est renforcée en introduisant dans le « buffer » une structure de super-réseaux de type GaAs/AIGaAs pour un canal dopé en matériau à base de GaAs (typiquement GalnAs), comme illustré en figure 2. Ce type de canal comprend ainsi un substrat S, avec un buffer épitaxié B, une structure super-réseau R, le canal dopé CP recouvert d'une couche isolante I, supportant les différents contacts ohmiques nécessaires à la mesure en tension et à la circulation d'un courant électrique. Typiquement, l'épaisseur des couches constitutives de la structure super-réseau sont de l'ordre de quelques Angströms, l'épaisseur du canal étant de l'ordre d'une centaine d'Angströms. Cette structure super-réseau crée une barrière de potentiel entre le canal dopé et le substrat mais qui s'avère être encore insuffisante pour des températures supérieures à 100°C.

C'est pourquoi l'invention propose une autre solution pour isoler le canal dopé. Il s'agit d'introduire dans la sonde ou le capteur à effet Hall une couche isolante à base d'oxyde d'aluminium. Plus précisément, l'invention a pour objet un capteur à effet Hall à base de matériaux semiconducteurs III-V de type GaAs ou lnP, comprenant un substrat en matériau III-V, une structure isolante, un canal dopé et une couche de surface, caractérisé en ce que la structure isolante comporte au moins une couche à base d'oxyde d'aluminium.

Selon une variante de l'invention, cette couche d'oxyde d'aluminium est comprise entre deux couches isolantes de matériau semiconducteur III-V.

Avantageusement, la couche à base d'oxyde d'aluminium présente une épaisseur d'environ 500 Angströms et 2 000 Angströms, le canal dopé ayant une épaisseur d'environ une centaine d'Angströms.

Avantageusement, la teneur en aluminium du matériau constitutif de la couche isolante est au moins de l'ordre de 90 %.

L'invention a aussi pour objet un procédé de réalisation d'un capteur à effet Hall à base de matériau semiconducteur III-V de type GaAs ou lnP comprenant un substrat, un canal dopé et une structure isolante entre le substrat et le canal dopé, caractérisé en ce qu'il comprend les étapes suivantes :
- la croissance épitaxiale sur le substrat d'un ensemble non dopé de couches à base de matériaux semiconducteurs III-V, dont une couche comprend une forte proportion d'aluminium, de manière à constituer la structure isolante ;
- la croissance épitaxiale d'une couche constitutive du canal dopé et d'une couche superficielle isolante ;
- le chauffage a une température comprise entre environ 350°C et 450°C, sous atmosphère oxydante de l'ensemble des couches épitaxiées sur le substrat de manière à transformer l'aluminium en oxyde d'aluminium isolant.

L'invention a encore pour objet un procédé de réalisation d'un capteur à effet Hall, comprenant une étape de gravure de l'ensemble des couches épitaxiées, de manière à définir des mesa constitutives des capteurs élémentaires isolés électriquement et découvrant la section de la couche à forte teneur en Al.

L'invention sera mieux comprise et d'autres avantages apparaîtront à la lecture de la description qui va suivre, donnée à titre non limitatif et grâce aux figures annexées parmi lesquelles :
- la figure 1 illustre le principe général d'un capteur à effet Hall ;
- la figure 2 illustre un capteur à effet Hall selon l'art antérieur ;
- la figure 3 illustre un capteur à effet Hall, selon l'invention ;
- la figure 4 illustre un premier exemple de capteur multiéléments à effet Hall ;

Nous allons décrire l'invention dans le cadre de capteur à effet Hall à base de GaAs, ce type de capteur pouvant tout aussi bien être réalisé à partir d'un matériau semiconducteur tel que InP.

Le capteur selon l'invention comprend sur un substrat isolant S, une structure de couches isolantes Sl, une couche de canal dopé CP, une couche supérieure isolante CS, sur laquelle sont réalisées les contacts ohmiques Ci.

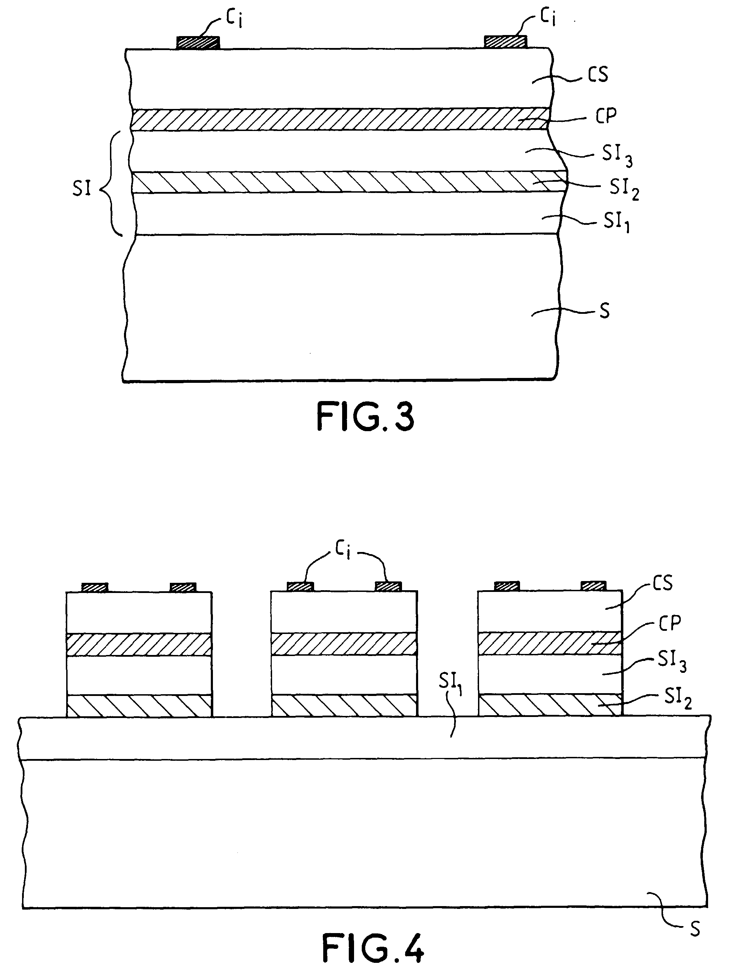

La figure 3 illustre un tel empilement de couches.

L'ensemble des couches est épitaxié sur un substrat isolant GaAs.

La structure isolante peut avantageusement comprendre une première couche d'interface en GaAs ou à base de GaAs de quelques milliers d'Angströms d'épaisseur Sl₁, épitaxiée sur le substrat GaAs, une couche intermédiaire en GaAlAs (Al > 90 %) d'une épaisseur comprise entre 500 Angströms et 2 000 Angströms, Sl₂, avec une forte teneur en aluminium puis une seconde couche d'interface à base de GaAs, Sl₃ (épais de quelques centaines d'Angströms).

Le canal dopé à base de GaAs (Nd > 810¹⁶ /cm³ p ≥ 100 Å) est déposé sur cette structure isolante.

Une couche de quelques milliers d'Angströms isolante à base de GaAs est déposée sur le canal dopé.

Nous allons décrire un premier exemple de procédé de réalisation d'un capteur multiéléments à effet Hall.
- Sur un substrat en GaAs, on réalise la croissance épitaxiale de l'ensemble des couches citées précédemment.
- Dans un second temps, on procède à l'isolation électrique et à la découverte de la section de la couche à forte teneur en AP à l'aide d'un procédé de photolitographie on définit les motifs dans la résine et on grave à l'aide d'une solution aqueuse, les mesa illustrées en figure 4.

Cette gravure est arrêtée dans l'épaisseur au niveau de la première couche d'interface isolante Sl1.
- Dans un troisième temps, on transforme la couche à base d'aluminium en oxyde d'aluminium. Cet oxyde est obtenu en introduisant la plaque à l'intérieur d'un four, dont la température se situe entre 350°C et 450°C, sous atmosphère oxydante, la durée du traitement dépend de la dimension de la couche et du motif, car cette oxydation s'effectue latéralement.

Puis l'on procède de manière classique, à la
- réalisation des contacts ohmiques à l'aide d'un procédé photolitographique, de métallisatoin à base de AuGe (eutectique) et d'un recuit dedit contact ;
- la passivation à base de Si₃N₄ pour protéger la surface ;
- recharge des contacts ohmiques après ouverture du passivant au-dessus de ceux-ci, avec une métallisation à base d'Au.

## Revendications

1. Capteur à effet Hall à base de matériaux semiconducteurs III-V de type GaAs ou lnP, comprenant un substrat en matériau III-V, un canal dopé et une structure isolante entre ledit canal et ledit substrat, caractérisé en ce que la structure isolante comprend une couche à base d'oxyde d'aluminium.

2. Capteur à effet Hall selon la revendication 1, caractérisé en ce que la structure isolante comprend l'empilement suivant :
- une couche isolante à base de matériau III-V épitaxiée sur le substrat ;
- une couche à base d'oxyde d'aluminium ;
- une couche isolante à base de matériau III-V.

3. Capteur à effet Hall selon l'une des revendications 1 ou 2, caractérisé en ce que l'épaisseur de la couche à base d'oxyde d'aluminium est comprise entre environ 500 et 2 000 Angströms.

4. Capteur à effet Hall selon l'une des revendications 1, à 3, caractérisé en ce qu'il comprend un ensemble de mesa sur un substrat semiconducteur en matériau III-V, chaque mesa comportant une structure isolante, un canal dopé, une couche superficielle isolante sur laquelle sont établis des contacts ohmiques.

5. Procédé de réalisation d'un capteur à effet Hall à base de matériau semiconducteur III-V de type GaAs ou lnP comprenant un substrat, un canal dopé et une structure isolante entre le substrat et le canal dopé, caractérisé en ce qu'il comprend les étapes suivantes :
- la croissance épitaxiale sur le substrat d'un ensemble non dopé de couches à base de matériaux semiconducteurs III-V, dont une couche à forte teneur en aluminium ;
- la croissance épitaxiale d'une couche constitutive du canal dopé et d'une couche superficielle isolante ;
- le chauffage a une température comprise entre environ 350°C et 450°C, sous atmosphère oxydante de l'ensemble des couches épitaxiées sur le substrat de manière à transformer l'aluminium de la couche à forte teneur en oxyde d'aluminium isolant.

6. Procédé de réalisation d'un capteur à effet Hall selon la revendication 5, caractérisé en ce que la couche comprenant de l'aluminium est comprise entre une couche inférieure isolante à base de matériau semiconducteur III-V et une couche supérieure isolante à base de matériau semiconducteur III-V.

7. Procédé de réalisation d'un capteur à effet Hall, multiéléments selon la revendication 6, caractérisé en ce qu'il comporte une étape de gravure de l'ensemble des couches épitaxiées, s'arrêtant à l'intérieur de la couche inférieure isolante de manière à définir des mesa constitutifs des capteurs élémentaires, ladite étape de gravure étant effectuée avec l'étape de chauffage.

8. Procédé de réalisation d'un capteur à effet Hall, selon l'une des revendications 5 à 7, caractérisé en ce que la couche à base d'aluminium comprend une concentration initiale de l'ordre de 90 %.
